# FASCICULE DE BREVET EUROPEEN

(11) **EP 2 636 064 B1**
(45) Date de publication et mention de la délivrance du brevet: **10.10.2018**
(21) Numéro de dépôt: 11787707.6
(22) Date de dépôt: 17.10.2011
(51) Int. Cl.: H01L 23/485, H01L 21/60

(54) **ELEMENTS DE CONNEXION POUR L'HYBRIDATION DE CIRCUITS ELECTRONIQUES**
VERBINDUNGSELEMENTE ZUR HERSTELLUNG VON ELEKTRONISCHEN HYBRIDSCHALTUNGEN
CONNECTING ELEMENTS FOR PRODUCING HYBRID ELECTRONIC CIRCUITS

(30) Priorité: 05.11.2010 FR 1059129
(43) Date de publication de la demande: 11.09.2013
(73) Titulaire: Commissariat à l'Énergie Atomique et aux Énergies Alternatives, 75015 Paris (FR)
(72) Inventeur: MARION, François, F-38950 Saint-Martin Le Vinoux (FR); GOUBAULT DE BRUGIERE, Baptiste, F-38500 La Buisse (FR); LAGARRIGUE, Stéphane, F-38140 Rives (FR); VOLPERT, Marion, F-38360 Sassenage (FR); HEITZMANN, Michel, F-38920 Crolles (FR)
(74) Mandataire: Cabinet Laurent & Charras
(86) Numéro de dépôt international: PCT/FR2011/052413
(87) Numéro de publication internationale: WO 2012/059659

(56) Documents cités:
- FR-A6- 2 042 800
- US-A- 5 457 879
- US-A- 5 669 774
- US-A- 5 928 005
- US-A1- 2005 282 411
- US-A1- 2008 169 563
- US-A1- 2010 163 869

## Description

### DOMAINE DE L'INVENTION

L'invention a trait au domaine de l'interconnexion de composants électroniques, et trouve particulièrement application dans les hybridations de type « flip-chip ».

### ETAT DE LA TECHNIQUE

L'hybridation « flip-chip », ou hybridation « face contre face », consiste généralement à réaliser deux circuits électroniques indépendamment l'un de l'autre, puis à les reporter l'un sur l'autre au moyen d'interconnexions remplissant à la fois la fonction de solidarisation mécanique et la fonction de connexion électrique. Par exemple, un imageur comprend d'une part un circuit de détection matricielle comportant une matrice de photosites sensibles à un rayonnement électromagnétique, et d'autre part un circuit comportant une électronique de lecture de la matrice de photosites. Ces deux circuits sont usuellement fabriqués indépendamment l'une de l'autre, puis hybridés.

Les premières hybridations « flip-chip » consistaient à hybrider les circuits au moyen de billes de soudure, usuellement en indium, qui, une fois solides, solidarisaient les circuits entre eux tout en formant des connexions électriques. Ce type d'hybridation ne permet cependant pas une densité élevée de connexions par unité de surface, et impose donc une limite à la miniaturisation des composants électroniques. Par ailleurs, une étape de chauffage sous atmosphère réductrice est nécessaire lors de l'hybridation pour fondre les billes de soudure, empêchant de fait l'emploi de matériaux ou composants électroniques ne supportant pas un tel chauffage.

Enfin, l'hybridation au moyen d'une soudure est définitive car elle nécessite la création de composés intermétalliques entre le matériau de soudure et le matériau sur lequel on soude. Le matériau sur lequel on soude est donc modifié et ne peut être utilisé deux fois. Une partie de la soudure est en outre consommée, rendant impropre une désolidarisation et re-soudure sans perdre en qualité. Le caractère définitif de la soudure s'avère fortement limitatif en termes de contrôle qualité et de réparation de circuit défectueux. Ainsi par exemple, pour tester le fonctionnement du circuit de détection d'un imageur, il est nécessaire de coupler celui-ci avec un circuit de lecture. Ce couplage se faisant par soudure, le circuit de lecture en charge du test est donc nécessairement le circuit de lecture définitif. De fait, si le circuit de détection s'avère défectueux, le circuit de lecture est également rejeté car il y est définitivement couplé, quand bien même il serait parfaitement opérationnel. De même, en cas de panne de l'un ou l'autre des circuits, le remplacement du circuit défectueux est impossible. L'ensemble hybridé est alors rejeté, y compris donc le circuit fonctionnant encore parfaitement.

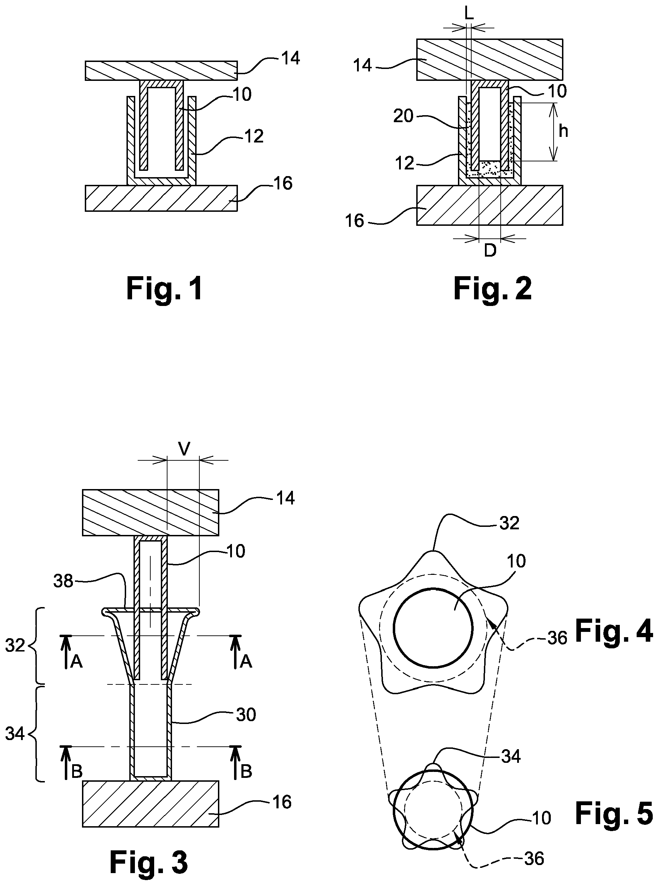

Plus récemment, une alternative aux billes de soudure, illustrée schématiquement à la figure 1 et décrite dans le document FR 2 936 359, prévoit la réalisation d'inserts cylindriques mâle **10** et femelle **12** sur des faces d'un premier et d'un second circuit **14, 16,** et le report du premier circuit **14** sur le second circuit **16** par insertion de l'insert mâle **10** dans l'insert femelle **14.**

Si la fabrication de tels inserts est possible avec une densité de surface élevée en raison des techniques employées, cette solution est en pratique difficilement viable. En effet, l'insert mâle **10** et l'insert femelle **12** doivent ensemble former une connexion électrique fiable, ce qui suppose donc que le diamètre externe de l'insert mâle **10** est sensiblement égal au diamètre interne de l'insert femelle **12** pour garantir le contact de leur surface. Le processus de fabrication des inserts doit donc être d'une extrême précision, tout comme doit l'être le processus d'alignement des inserts en vue de l'insertion de l'insert mâle dans l'insert femelle.

Le document JP 01226160 propose une interconnexion analogue, la différence principale résidant dans le fait que l'insert mâle est plein et de diamètre externe choisi de manière à obtenir une insertion en force dans l'insert femelle avec une déformation élastique et plastique de ce dernier. Là encore, ceci suppose une extrême précision dans les processus de fabrication et d'alignement. De plus, en raison des matériaux utilisés, à savoir des métaux pour obtenir une connexion électrique, la déformation de l'insert femelle est non réversible. En effet, l'interconnexion des inserts mâle et femelle est réalisée en force en utilisant une déformation plastique des matériaux, et donc une déformation irréversible de ceux-ci. Une fois hybridés, il n'est donc plus possible de désolidariser les deux circuits sans provoquer la destruction des éléments femelles.

Pour pallier ces problèmes, il est possible de remplir l'insert femelle avec un matériau de soudure **20,** comme illustré à la figure 2 et décrit dans le document FR 2 936 359. De la sorte, le matériau de soudure **20** forme un joint électrique entre l'insert mâle **12** et l'insert femelle **14,** permettant ainsi de relâcher les contraintes sur la précision de leur fabrication et de leur alignement.

La réintroduction d'un matériau de soudure dans l'interconnexion des circuits s'accompagne toutefois des désavantages inhérents à ce type d'hybridation, c'est-à-dire la nécessité d'un chauffage, ainsi que l'aspect définitif de l'hybridation, comme cela a été expliqué précédemment.

Le document US 5,457,879 divulgue un procédé d'interconnexion qui prévoit l'insertion d'un élément mâle plein dans un élément femelle. Le document US 2005/0282411 A1 divulgue un procédé analogue dans lequel l'élément femelle présente une section transversale ondulée.

### EXPOSE DE L'INVENTION

Le but de la présente invention est de proposer une interconnexion ne nécessitant pas l'utilisation de processus de fabrication et d'alignement précis, ne nécessitant pas l'emploi de matériau de soudure, et qui soit réversible. Elle vise également à s'affranchir de la problématique née du guidage des éléments de connexion entre eux.

A cet effet, l'invention a pour objet un élément de connexion selon la revendication 1, comportant notamment une partie creuse de forme évasée pour la réception et le guidage d'un élément de connexion mâle et une partie creuse d'enfichage, formée dans le prolongement de la partie de forme évasée, pour l'enfichage de l'élément de connexion mâle, dans lequel la partie d'enfichage est réalisée dans un matériau déformable et présente une section transversale ondulée de diamètre interne avant l'enfichage, inférieur au diamètre externe de l'élément mâle avant l'enfichage, de manière à se dilater lors de l'enfichage de l'élément de connexion mâle.

En d'autres termes, la forme évasée de l'élément femelle permet de recevoir un élément mâle sans nécessiter un alignement précis et de guider celui-ci vers la partie de l'élément femelle avec laquelle il est destiné à coopérer pour former la connexion électrique et mécanique. En outre, cette forme évasée étant de diamètre « globalement » décroissant, les parois de l'élément mâle et de l'élément femelle viennent nécessairement au contact l'une de l'autre, et cela même si le processus de fabrication utilisé pour leur construction est imprécis.

Par ailleurs, en raison de la forme ondulée de la partie d'enfichage de l'élément femelle, l'insertion en force de l'élément mâle ne provoque pas un étirement élevé du matériau constitutif de cette partie. Ainsi, la déformation subie n'est pas irréversible et le retrait de l'élément mâle provoque le retour de la partie d'enfichage à une forme proche de la forme initiale. L'élément mâle peut ainsi être de nouveau inséré dans l'élément femelle tout en garantissant une connexion électrique et mécanique de qualité identique. L'interconnexion n'est donc pas définitive. Deux circuits hybridés à l'aide de tels éléments de connexion peuvent donc être séparés, par exemple pour des raisons de test, de remplacement ou autres, et de nouveau être hybridés.

Un élément de connexion mâle est destiné à coopérer avec un élément de connexion femelle selon l'invention qui comporte une partie creuse de forme évasée pour la réception et le guidage de l'élément de connexion mâle et une partie creuse d'enfichage, formée dans le prolongement de la partie de forme évasée, pour l'enfichage de l'élément de connexion mâle, dans lequel une partie à enficher de l'élément de connexion mâle est réalisée dans un matériau déformable et présente une section transversale ondulée de diamètre externe avant l'enfichage supérieur au diamètre interne avant l'enfichage de la partie d'enfichage de l'élément femelle, de manière à se contracter lors son enfichage dans ladite partie d'enfichage.
En d'autres termes, la partie à enficher de section ondulée garantit la réversibilité de l'interconnexion, pour des raisons analogues à celles décrites ci-dessus.
L'invention a également pour objet un système de connexion d'un premier composant électronique avec un second composant électronique selon la revendication 2, comportant notamment au moins une paire d'éléments de connexion mâle et femelle respectivement fixés au premier et second composants. Selon l'invention :
▪ l'élément de connexion femelle comporte une partie creuse de forme évasée pour la réception et le guidage de l'élément de connexion mâle et une partie creuse d'enfichage, formée dans le prolongement de la partie de forme évasée, pour l'enfichage de l'élément de connexion mâle ;
▪ une partie à enficher de l'élément de connexion mâle a un diamètre externe avant l'enfichage supérieur à un diamètre d'un cercle inscrit de la partie d'enfichage de l'élément de connexion femelle ;
▪ et la partie à enficher de l'élément de connexion mâle est réalisée dans un matériau déformable et présente une section transversale ondulée sur toute sa hauteur, de manière à se contracter lors de son enfichage dans la partie d'enfichage de l'élément femelle, et/ou la partie d'enfichage de l'élément de connexion femelle est réalisée dans un matériau déformable et présente une section transversale ondulée sur toute sa hauteur, de manière à se dilater lors de l'enfichage de la partie à enficher de l'élément mâle.

L'invention a également pour objet un procédé de fabrication d'un élément de connexion femelle du type précité selon la revendication 3, consistant:
▪ à réaliser une couche apte à être gravée ;
▪ à déposer sur la couche apte à être gravée une couche non sensible à la gravure et comportant une ouverture à profil ondulé ;
▪ à appliquer une gravure isotrope sur ladite ouverture de manière à former, dans la couche apte à être gravée, la partie de forme évasée ;
▪ à appliquer une gravure anisotrope sur ladite ouverture de manière à former, dans la couche apte à être gravée, la partie d'enfichage ; et
▪ à retirer la couche non sensible à la gravure.

L'invention a également pour objet un procédé de fabrication d'un élément de connexion femelle du type précité selon la revendication 4, consistant :
▪ à réaliser un empilement d'au moins une couche supérieure et une couche inférieure aptes à être gravées, la couche supérieure étant gravée plus rapidement que la couche inférieure ;
▪ à déposer sur la couche supérieure une couche non sensible à la gravure et comportant une ouverture à profil ondulé ;
▪ à appliquer une gravure sur ladite ouverture de manière à former, dans les aux moins deux couches aptes à être gravées, la partie de forme évasées et la partie d'enfichage ; et
▪ à retirer la couche non sensible à la gravure.

Selon un mode de réalisation, la ou les couches aptes à être gravées sont des couches de polymère de type diimide.

Selon un mode de réalisation de l'invention, le procédé comprend le dépôt d'une couche de métal sur la paroi interne des parties gravées.

Selon un mode de réalisation de l'invention, le procédé comprend le retrait de la ou des couches aptes à être graver.

### BREVE DESCRIPTION DES FIGURES

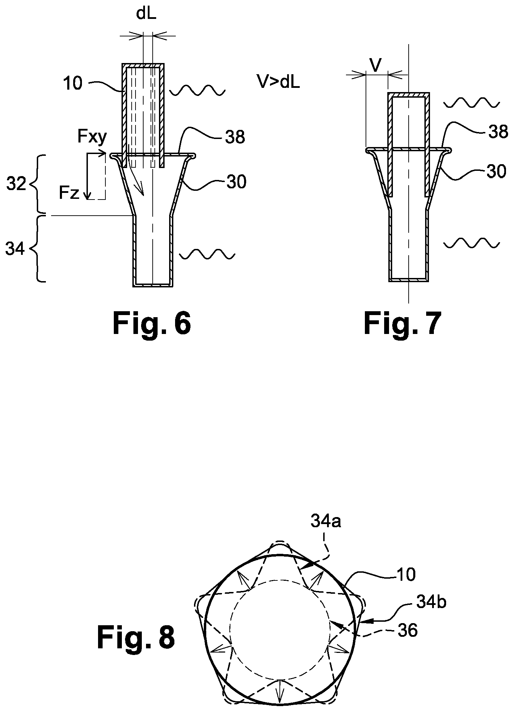

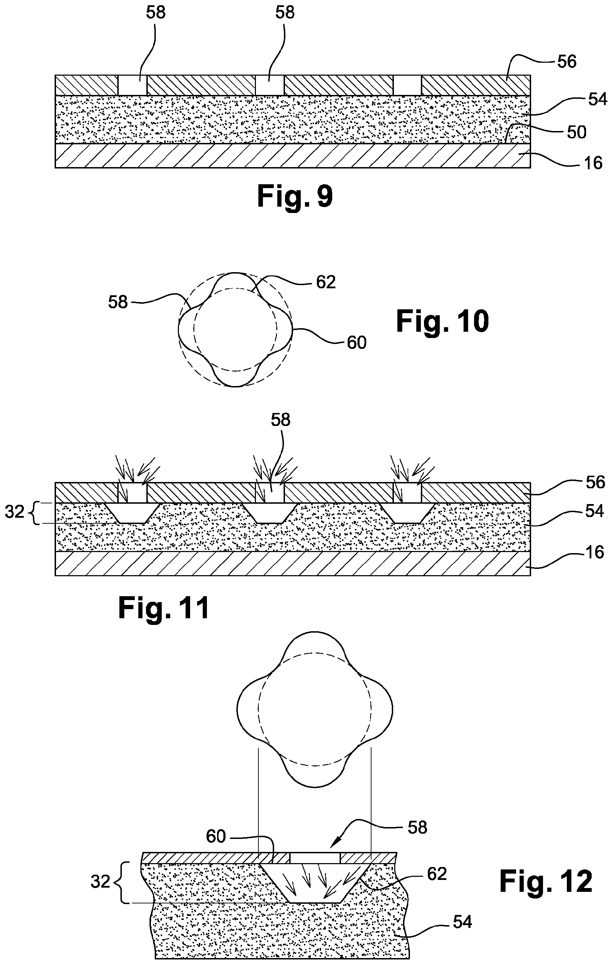

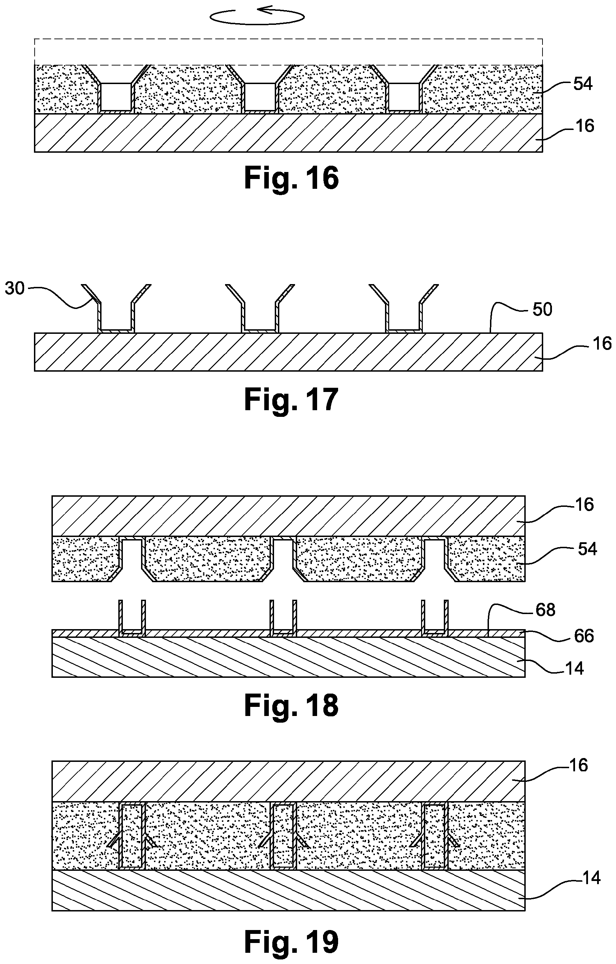

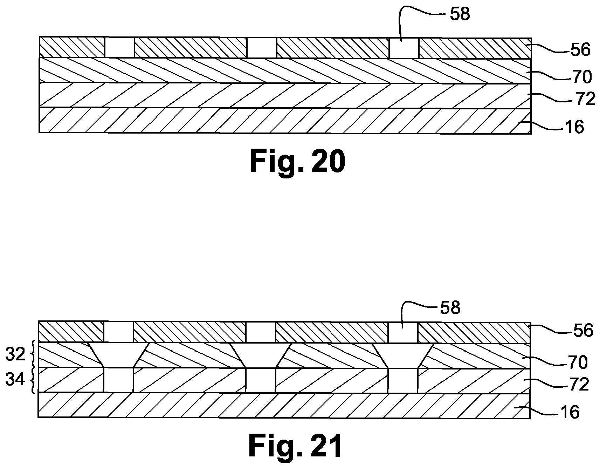

L'invention sera mieux comprise à la lecture de la description qui va suivre, donnée uniquement à titre d'exemple, et réalisée en relation avec les dessins annexés dans lesquels des références identiques désignent des éléments identiques ou analogues, et dans lesquels :
▪ la figure 1 est une vue en coupe schématique d'une interconnexion selon un premier état de la technique ;
▪ la figure 2 est une vue en coupe schématique d'une interconnexion selon un second état de la technique ;
▪ la figure 3 est une vue schématique en coupe d'une interconnexion selon l'invention ;
▪ la figure 4 est une vue schématique en coupe selon le plan A-A de la figure 3 ;
▪ la figure 5 est une vue schématique en coupe selon le plan B-B de la figure 3 ;
▪ les figures 6 et 7 sont des vues schématiques en coupe illustrant la réception et le guidage de l'élément mâle par la partie évasée de l'élément femelle ;
▪ la figure 8 est un tracé illustrant la partie d'enfichage de l'élément de connexion femelle avant l'enfichage et après l'enfichage de l'élément mâle ;
▪ les figures 9 à 17 sont des vues schématiques en coupe illustrant un premier procédé de fabrication d'un élément de connexion femelle selon l'invention ;
▪ les figures 18 et 19 sont des vues schématique en coupe illustrant une interconnexion avec un matériau de remplissage entre les deux circuits hybridés ; et
▪ les figures 20 et 21 sont des vues schématiques en coupe illustrant un second procédé de fabrication d'un élément de connexion femelle selon l'invention.

### DESCRIPTION DETAILLEE DE L'INVENTION

Sur la figure 3, une interconnexion selon l'invention est représentée. Elle comporte un élément de connexion femelle métallique creux **30** comportant une partie évasée **32** se prolongeant par une partie d'enfichage **34.**

Comme cela est visible sur les figures 4 et 5, qui sont respectivement des vues en coupe selon les plans A-A et B-B de la figure 3, l'élément femelle **30** présente une section transversale ondulée, avec un cercle inscrit **36** dont le diamètre décroit dans la partie évasée **32** depuis l'ouverture **38** de l'élément femelle **30** jusqu'à la partie d'enfichage **34,** et dont le diamètre inscrit **36** est sensiblement constant dans la partie d'enfichage **34.**

L'élément de connexion mâle **10** prend quant à lui la forme d'un cylindre métallique creux. Son diamètre extérieur est inférieur au diamètre du cercle inscrit **36** de l'ouverture **38** de l'élément femelle **30,** mais est supérieur au diamètre inscrit **36** de la partie d'enfichage **34** de l'élément femelle **30.**

Les matériaux constitutifs des éléments de connexion mâle **10** et femelle **30** sont avantageusement choisis parmi le Cu et ses composés (CuBe par exemple), le Ni et ses composés (NiBe par exemple), le W et ses composés (WN et WSi par exemple), le Ti et ses composés (TiN et TiW par exemple), l'Au et ses composés (AuSn par exemple) et le Pt et ses composés (PtSi par exemple).

Plus particulièrement, les matériaux sont choisis pour être à la fois robuste et bon conducteur d'électricité. De manière avantageuse, les éléments mâles peuvent être formés en un premier matériau de bonne tenue mécanique, comme le CuBe par exemple, recouvert d'un second matériau de bonne conduction électrique, comme l'Au par exemple.
Comme illustré aux figures 6 et 7, la partie évasée **32** de l'élément femelle **30** a pour fonction de recevoir l'élément mâle **10** et de guider celui-ci vers la partie d'enfichage **34.**

Selon l'invention, le diamètre inscrit à l'ouverture **38** de l'élément femelle **30** est supérieur au diamètre externe de l'élément mâle **10** d'au moins la précision *dL* de l'outillage utilisé pour positionner l'élément mâle **10** au dessus de l'élément femelle **30** lors de l'hybridation des circuits électroniques **14, 16.** De cette manière, il est garanti que l'élément mâle **10** est inséré dans l'élément femelle **30.**

La forme évasée **32** permet en outre un auto-alignement des éléments **10** et **30.** En effet, lorsque l'élément mâle **10** vient au contact de la paroi interne de la partie évasée **32,** la force verticale exercée sur cette paroi inclinée créée en réaction une composante horizontale qui aligne automatiquement les deux éléments de connexion **10** et **30,** comme cela est visible sur la figure 7. L'élément mâle **10** se présente ainsi parfaitement aligné à l'entrée de la partie d'enfichage **34.**
L'enfichage proprement dit de l'élément mâle **10** dans l'élément femelle **30** s'effectue alors par une poussée verticale de l'élément mâle dans la partie d'enfichage **34.** La partie **34,** qui présente un diamètre inscrit **36** inférieur au diamètre externe de l'élément mâle **10,** se dilate alors aisément en raison de son profil ondulé, combiné au le fait qu'elle est constituée d'un matériau déformable, ici un métal.
La figure 8 illustre la section transversale de la partie **34** d'enfichage avant et après l'enfichage de l'élément mâle **10.** Comme visible sur cette figure, la section de la partie **34** passe d'un profil ondulé **34a** à un profil convexe **34b** dans lequel s'inscrit l'élément mâle **10.** Ce dernier, enfiché en force dans la partie **34,** est alors en contact avec cette dernière en de nombreux points, assurant ainsi une connexion électrique fiable entre ces deux éléments de connexion **10, 30.**

Par « déformable », il doit être ici compris un matériau capable de subir la déformation provoquée par l'insertion en force de l'élément mâle dans la partie **34** sans dommage et de manière réversible. En pratique, la qualité déformable dépend donc non seulement de la nature même du matériau, mais également de l'épaisseur des parois de la partie d'enfichage **34** et du profil ondulé de celle-ci. En pratique toujours, il est possible que tout matériau acquière cette qualité de déformation pourvu que l'épaisseur et/ou le profil ondulé soient choisis de manière appropriée.
La force « F » verticale exercée sur l'élément mâle **10** pour son enfichage dans la partie **34** de l'élément femelle **30** détermine la profondeur d'enfichage en fonction des géométries en cause. Dès que la résultante verticale des forces de déformation est égale à la force « F » exercée sur l'élément mâle, la progression de l'insertion est stoppée.
En supposant en première approximation que la déformation subie par la partie d'enfichage **34** est de nature élastique, la désinsertion de l'élément mâle requiert alors une force opposée à la force « F », la partie d'enfichage **34** reprenant sensiblement sa forme initiale à mesure du retrait de l'élément **10.** Il est ainsi remarquable que le profil transversal ondulé de cette partie **34** se comporte comme un ressort. De fait, il est possible d'enficher et de désenficher les éléments mâle **10** et femelle **30** aussi souvent que souhaité.
Dans le mode de réalisation décrit, l'élément mâle **10** est un cylindre métallique creux. Il subit donc également une déformation lors de son enfichage. Dans une variante qui n'est pas comprise dans l'objet de l'invention, l'élément mâle peut être plein auquel cas, il ne subit sensiblement aucune déformation.

Par ailleurs, la forme de l'élément mâle n'est pas limitée à un cylindre. L'élément mâle peut par exemple être plus large en bas qu'en haut, ce qui permet de renforcer la tenue mécanique.
En outre, il a été décrit un mode de réalisation dans lequel l'élément femelle présente dans sa partie d'enfichage un profil ondulé pour pouvoir subir une déformation réversible grâce à un effet de ressort. En variante, ou de manière complémentaire au profil ondulé de l'élément femelle **30,** l'élément mâle présente une section transversale ondulée de sorte qu'il subit lors de son enfichage une contraction réversible mettant également en oeuvre un effet ressort.

De manière avantageuse, à la fois l'élément mâle et l'élément femelle présentent un tel profil ondulé, de sorte que la force nécessaire pour l'enfichage de ces deux éléments est réduite.

On notera par ailleurs, qu'il est également possible de prévoir un remplissage de l'élément femelle avec un matériau de soudure qui vient combler l'espace entre l'élément mâle et l'élément femelle et ainsi former un joint électrique et mécanique. L'utilisation d'un matériau de soudure dépend évidemment de l'application visée, mais il est remarquable que le profil ondulé de l'élément mâle et/ou de l'élément femelle garde tout son intérêt. En effet par exemple, avant de définitivement hybrider deux circuits ensemble par l'utilisation d'un matériau de soudure, des tests préliminaires peuvent être réalisés sur chacun d'entre eux. Une hybridation sans matériau de soudure est alors avantageusement mise en oeuvre exploitant la réversibilité de l'enfichage des éléments mâle et femelle. Une fois testés et approuvés, les circuits sont alors prêts pour une hybridation définitive avec le matériau de soudure.

De même, indépendamment de la possibilité offerte de réaliser des tests avec enfichage réversible, il est remarquable que la force exercée pour obtenir un enfichage fiable des éléments femelle et mâle est bien moindre dans l'invention que la force nécessaire pour enficher en force des éléments mâle et femelle de section circulaire. Il est remarquable à cet égard que plus la force exercée est importante plus le contrôle de sa verticalité est cruciale. En effet, la composante transversale d'une force non verticale induit un risque non négligeable de casse de l'un ou l'autre des éléments de connexion. On comprendra aisément combien il peut être délicat d'enficher en force des éléments dont les parois ont une épaisseur inférieure au micromètre.

Il va à présent être décrit en relation avec les figures 9 à 17 un procédé de fabrication d'éléments femelles à section transversale ondulée sur la face d'un circuit microélectronique à hybrider.

Les éléments de connexion mâles sont quant à eux des cylindres métalliques creux par exemple réalisés à l'aide du procédé décrit dans le document FR 2 928 033.

Le procédé débute (figure 9) avec le dépôt, sur la face à hybrider **50** d'un circuit microélectronique **16,** d'une couche dite « sacrificielle » **54** sensible à la gravure, et préférentiellement réalisée dans un polymère de type polyimide. Ce polymère présente l'avantage de supporter des températures de procédé élevées, de l'ordre de 350-400°C, par exemple utilisées lors du dépôt.

Une couche **56** en matériau dur non sensible à la gravure, par exemple constituée de SiO, de SiN, ou de métal, est ensuite déposée sur la couche sacrificielle **54,** puis des ouvertures **58** sont réalisées au travers de la couche dure **56** aux emplacements souhaités pour les éléments de connexion femelles (figure 9).

Les ouvertures **58,** dont une vue de dessus est illustrée à la figure 10, sont réalisées par exemple par photolithographie au moyen d'un masque, comme cela est connu en soi de l'état de la technique. Les ouvertures **58,** dans l'exemple toutes identiques, ont un profil ondulé, sont inscrites dans un cercle externe « Cext » **60** et inscrivent un cercle interne « Cint » **62.**

A titre d'exemple numérique, la couche sacrificielle **54** a une épaisseur de 5 micromètres, le diamètre Cext des ouvertures **58** est égal à 5,5 micromètres et le diamètre Cint des ouvertures **58** est égal à 4,5 micromètres.

Le procédé se poursuit alors (figure 11) par l'application d'une gravure partielle isotrope, de la couche sacrificielle **54** au travers des ouvertures **58,** c'est-à-dire une gravure isotrope qui n'est pas réalisée sur la totalité de l'épaisseur de la couche **54.** La gravure est par exemple réalisée par l'application d'un plasma d'O₂ haute pression sans assistance d'un bombardement ionique directif ou par l'application d'une chimique liquide, telle qu'une attaque polyimide liquide décrite dans le document US 4 846 929 ou une gravure avec TMAH (tetramethylammonium hydroxide).

La gravure isotrope attaque ainsi le polymère de la couche sacrificielle **54** dans toutes les directions. Comme cela est visible à la figure de détails 12, une surgravure latérale **60** sous la couche dure **56** est réalisée. En outre, la gravure isotrope attaque la couche sacrificielle **54** selon une pente d'isotropie **62,** dont la valeur dépend des caractéristiques du processus de gravure. Par exemple, dans une gravure plasma oxygène, en faisant varier la tension entre les électrodes de commande des décharges plasma, une assistance « ionique » mécanique anisotrope verticale est créée. Plus particulièrement, la pente d'isotropie **62** augmente si la tension augmente. On notera qu'il est possible de faire varier d'autres paramètres et que le contrôle de la pente d'isotropie est un mécanisme parfaitement maîtrisé.

Notamment, concernant l'obtention de la pente d'isotropie **62,** plusieurs essais avec différentes valeurs de paramètre peuvent être menés jusqu'à ce qu'à obtention de la pente d'isotropie **62** souhaitée.

On peut faire varier différents paramètres du procédé de gravure plasma, notamment :
- le temps de gravure,
- le débit des gaz (oxygène essentiellement, azote),
- la pression des gaz : par exemple, lorsque la pression augment dans l'enceinte de gravure, la gravure est plus isotrope.
- la puissance :
   o appliquée sur la plaquette (le wafer) : en augmentant cette puissance, la gravure est plus anisotrope
   o appliquée à la source : en augmentant cette puissance, la gravure est plus isotrope.

La partie de forme évasée **32** des éléments de connexion femelles est ainsi formée.

Par ailleurs, la gravure, qu'elle soit isotrope ou non, attaque la couche sacrificielle **54** de sorte que, quelle que soit la hauteur considérée dans la couche sacrificielle **54,** la section transversale d'une portion attaquée de la couche **54** est homothétique à l'ouverture **58** correspondante.

Dans l'exemple numérique, la pente d'isotropie est égale à 30° durant l'attaque des deux premiers micromètres de la couche sacrificielle **54,** c'est-à-dire que chaque micromètre de gravure dans l'épaisseur de la couche sacrificielle **54** donne lieu à un élargissement latéral **60** des dimensions de 0,5 micromètre par côté sous le masque dur **56** et à un élargissement nul en bas de gravure. Ainsi, en stoppant la gravure lorsque celle-ci a attaqué 2 micromètres d'épaisseur de la couche sacrificielle **54,** la partie gravée dans une ouverture **58** est caractérisée dimensionnellement par :
▪ sous le masque dur **56** :
   - un cercle intérieur dont le diamètre passe de 4,5 à 6,5 micromètres ;
   - un cercle extérieur dont le diamètre passe de 5,5 à 7,5 micromètres ;
▪ à 2 micromètres de profondeur sous le masque dur **56** :
   - un cercle intérieur dont le diamètre reste à 4,5 micromètres ;
   - un cercle extérieur dont le diamètre reste à 5,5 micromètres.

En pratique, les dimensions des ouvertures **58** sont choisies pour tenir compte de la sous-gravure latérale **60.** Ainsi par exemple, si l'élément mâle destiné à coopérer avec un élément femelle est un cylindre de diamètre égal à 5 micromètres, et que la précision des machines utilisées pour enficher les éléments mâle et femelle est égale à 0,5 micromètre, les ouvertures **58** dans le masque dur sont choisies de sorte que leur cercle extérieur présente un diamètre égal à 5,5 micromètres et que leur cercle interne présente un diamètre égal à 4,5 micromètres, menant ainsi à des parties supérieures évasées des éléments femelles ayant un diamètre de cercle interne à l'ouverture égale à 6,5 micromètres compatible avec la précision des machines.

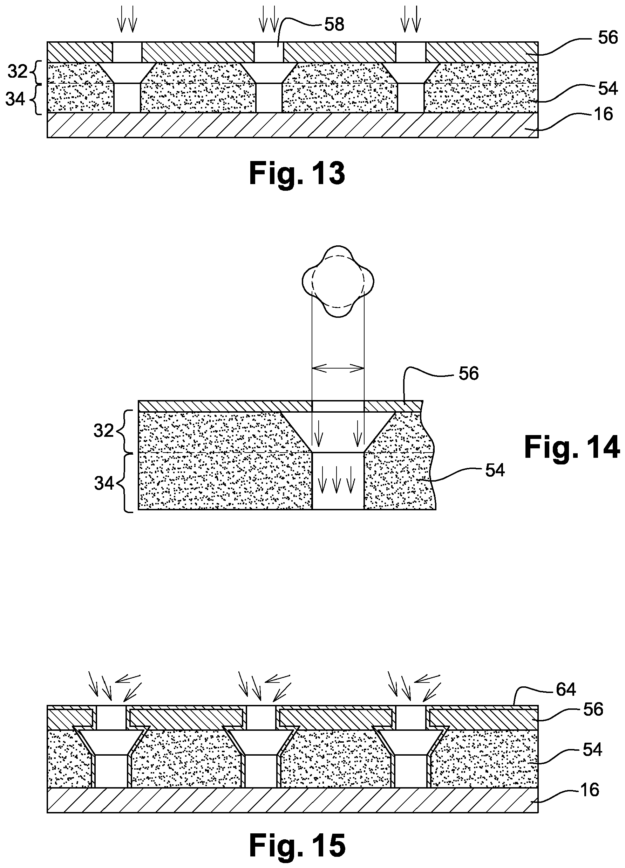

Le procédé se poursuit alors par l'application d'une gravure anisotrope dans l'épaisseur restante de la couche sacrificielle en polymère **54,** comme par exemple l'application d'un plasma d'O₂ basse pression avec assistance d'un bombardement ionique directif (figures 13 et 14) ou par exemple l'application d'un usinage ionique.

Le caractère anisotrope de la gravure a ainsi pour effet de transférer la géométrie des ouvertures **58** dans l'épaisseur restante de la couche sacrificielle **54** sans surgravure latérale. La partie d'enfichage **34** des éléments de connexion femelle est ainsi formée dans le prolongement de la partie de forme évasée **32** avec une section transversale sensiblement identique au profil des ouvertures **58,** et donc notamment une section transversale ondulée dont le diamètre du cercle inscrit est égal à 4,5 micromètres dans l'exemple numérique.

Le procédé se poursuit alors par le dépôt conforme d'une couche de métal dur **64,** avantageusement en CuBe, sur la surface de l'ensemble (figure 15), c'est-à-dire que l'épaisseur du dépôt de métal dur est constante sur toute la surface qu'il recouvre, y compris sur la partie de forme évasée **32.** De manière avantageuse, un dépôt de type CVD (acronyme anglo-saxon de « *Chemical Vapor Déposition* ») est réalisé pour former la couche **64.**

La couche de métal dur **64** se dépose ainsi sur la paroi interne des parties gravées de la couche sacrificielle **54,** ce qui permet de former des parois mécaniquement résistantes et électriquement conductrices. De préférence, le dépôt est réalisé au moyen d'un dépôt chimique en phase vapeur, ce type de dépôt garantissant une bonne conformité de la couche déposée sur la paroi des parties gravées. Par exemple, une couche de cuivre d'une épaisseur de 0,2 micromètres est déposée.

Un polissage mécanique est ensuite réalisé pour ôter la couche de métal dur **64** et la couche de métal dur **56** à la surface de l'ensemble, de manière à faire apparaître la couche sacrificielle **54** (figure 16) et isoler électriquement les éléments de connexion femelles les uns des autres.

Dans une première variante, le procédé se poursuit par le retrait de la couche sacrificielle **54,** de manière à libérer les éléments de connexion femelles **30** (figure 17). Le procédé se poursuit alors de manière optionnelle par le dépôt sur les éléments femelles **30** d'une couche d'or, par exemple d'une épaisseur de 0,1 micromètre, afin de préserver une bonne qualité de surface. Une telle couche d'or permet notamment d'éviter une oxydation du matériau dur des éléments femelles **30** lorsque le composant sera stocké avant utilisation. En effet, en absence de précaution particulière, un oxyde natif se forme naturellement à la surface du matériau dur des éléments femelles **30,** ce qui nuit à la qualité de la connexion électrique ultérieurement formée avec les éléments mâles.

De manière similaire, les éléments de connexion mâles sont également recouverts d'une couche d'or. Ce recouvrement est par exemple réalisé au moyen du dépôt d'une couche d'or suivi d'une gravure à l'aide d'un masque permettant de graver la couche d'or autour de chaque élément de connexion mâle et femelle, de manière à ne recouvrir que ces derniers avec une couche d'or, avec optionnellement le recouvrement d'une zone restreinte autour de chacun d'entre eux.

Dans une seconde variante du procédé, la couche sacrificielle **54** est conservée afin de former un matériau de remplissage entre les deux circuits hybridés, comme cela est visible aux figures 18 et 19, qui présentent les circuits à hybrider respectivement avant et après l'enfichage des éléments de connexion mâles **10** et femelles **30.** On notera que le matériau de la couche sacrificielle **54,** préférentiellement un polymère de type diimide, présente une élasticité lui permettant de se déformer lors de l'insertion des éléments mâles, ce qui permet de conserver ladite couche sacrificielle et donc d'augmenter la résistance mécanique de l'ensemble une fois circuits hybridés.

Ainsi donc une économie de procédé est réalisée car l'hybridation au moyen d'éléments creux est usuellement complétée par une étape d'enrobage afin de protéger lesdits éléments qui sont plus fragiles que les interconnexions par billes de soudure antérieurement utilisées. En outre, la couche sacrificielle **54** présente par construction une bonne planéité en raison du processus employé pour ôter les couches dures **56** et **64,** ce qui permet de corriger la non-planéité du substrat inférieur, d'améliorer les rendements de connexion. En outre, grâce au polyimide **54,** on rattrape les éventuelles différences de hauteur, comme des marches par exemple.

De manière avantageuse, et si l'application le nécessite, la face **66** du circuit **14** sur laquelle sont formés les éléments mâles **10** est recouverte d'une couche **68** de matériau polymérisable, et avantageusement un matériau polymérisable en deux étapes, comme par exemple une résine époxy, telle que celle divulguée dans le document US 7 579 392. Ce type de résine, usuellement désignée sous le terme « Bstage », présente l'avantage de réticuler en deux étapes de chauffage. Lors d'une première étape de chauffage à une première température, la résine réticule partiellement et passe d'un état liquide à un état malléable, ce qui permet de la mettre en forme. Suite à une deuxième étape de chauffage, à une seconde température supérieure à la première température, la résine réticule alors complètement et devient ainsi solide.

Ceci permet de coller les deux circuits **14** et **16** entre eux après hybridation par collage « face contre face » avec étalement de la couche **68** en couche mince lorsqu'elle est dans son état malléable suite à la première étape de chauffage, suivi de la solidarisation des circuits **14** et **16** par la solidification de la couche **68** suite à la seconde étape de chauffage, comme cela est par exemple décrit dans le document US 7 579 392.

De manière optionnelle, et en fonction de l'application visée, la surface interne des éléments femelles **30** est recouverte d'une couche de matériau de soudure **70** afin de réaliser un joint mécanique et électrique une fois les éléments mâles enfichés.

Comme dit plus haut, les éléments de connexion mâle sont quant à eux par exemple réalisés à l'aide du procédé décrit dans le document FR 2 928 033.

En variante, les éléments mâles peuvent être réalisés de manière analogue au procédé décrit précédemment en attaquant une couche sacrificielle à l'aide d'une gravure uniquement anisotrope. Les ouvertures pratiquées dans la couche dure recouvrant la couche sacrificielle sont circulaires, auquel cas des éléments mâle cylindrique et creux sont obtenus, ou ont un profil ondulé, auquel cas des éléments mâles creux de section transversale ondulée sont obtenus.

Dans le procédé précédemment décrit, la hauteur de la partie de forme évasée **32** des éléments de connexion femelle est réglée par la durée de la gravure isotrope appliquée à la couche **54.** Or, malgré tout le soin apporté à la formation du matériau de la couche **54** et à la réalisation de la gravure, des inhomogénéités peuvent malgré tout apparaître lors de la gravure, menant ainsi à des parties de forme évasée **32** de hauteur différente, et donc à une hybridation ultérieure de moins bonne qualité.

Il va à présent être décrit, en relation avec les figures 20 et 21, un second procédé de fabrication des éléments de connexion femelles selon l'invention, permettant de contrôler la hauteur des parties de forme évasée des éléments de connexion femelle de manière plus précise, et cela quelle que soit la qualité du matériau dans lequel est réalisée la gravure, et quelle que soit la qualité de la gravure utilisée.

Selon ce second mode de réalisation, la couche sacrificielle **54** est remplacée par un empilement de deux couches de polymère **70, 72,** avantageusement de type diimide, se gravant à des vitesses différentes (figure 20), la couche supérieure **70** se gravant plus rapidement que la couche inférieure **72.**

Une gravure isotrope est alors réalisée dans la couche supérieure **70** jusqu'à la couche inférieure **72,** d'une manière analogue à la gravure isotrope de la couche **54** du mode de réalisation précédent. Il se forme alors les parties de forme évasée **32.** Notamment, comme pour le mode de réalisation précédent, le profil des ouvertures **58** est reporté dans les parties gravées qui présentent ainsi des sections homothétiques audit profil.

Toutefois, à la différence du mode de réalisation précédent, la couche inférieure **72** joue ici la fonction de couche d'arrêt pour la gravure réalisée dans la couche supérieure **70.** Notamment, en choisissant une couche inférieure **72** se gravant à une vitesse nettement inférieure à la vitesse de gravure de la couche supérieure **70,** la gravure de cette dernière s'arrête sensiblement à l'interface avec la couche inférieure **72.** La hauteur des parties de forme évasée **32** est alors réglée par la hauteur de la couche supérieure **70,** et donc par le processus de formation de celle-ci, à savoir par exemple le processus de dépôt utilisé.

Le procédé se poursuit alors par l'application d'une gravure anisotrope, qui forme alors dans la couche inférieure **70** les parties droites **34** des éléments de connexion femelle, d'une manière analogue au premier mode de réalisation (figure 21). Notamment, comme pour le mode de réalisation précédent, le profil des ouvertures **58** est reporté dans les parties gravées qui présentent ainsi des sections homothétiques audit profil.

Avantageusement, la gravure des couches supérieure **70** et inférieure **72** est réalisée lors d'un même processus de gravure, par exemple à l'aide d'une gravure par plasma d'O₂. Comme cela est connu en soi, le caractère isotrope et anisotrope de la gravure peut être réglé à l'aide de la tension utilisée pour la décharge plasma.

Une fois la gravure des couches sacrificielles supérieure et inférieure réalisée, le procédé se poursuit alors de manière analogue au procédé selon le premier mode de réalisation.

Grâce à l'invention, il est obtenu les avantages suivants :
▪ une mise en regard des éléments mâle et femelle simplifiée qui ne nécessite pas un outillage d'une extrême précision. La mise en regard peut en outre être réalisée à température ambiante alors que l'état de la technique utilisant des soudures nécessite de porter l'ensemble au moins à la température de fusion du matériau de soudure, et/ou de porter l'ensemble à une pression très élevée pour diminuer la température de fusion du matériau de soudure ;
▪ un auto-alignement intrinsèque des éléments mâle et femelle ;
▪ un enfichage réversible, les éléments mâle et femelle pouvant être enfichés et désenfichés si nécessaire. Ceci permet de remplacer des circuits défectueux, de tester préalablement les circuits à hybrider, avantageusement à l'aide d'un nombre limité de, voire un unique, circuits de test spécifiquement conçus à cet effet ;
▪ la possibilité de ne pas utiliser de matériau de soudure pour garantir une connexion électrique. L'absence de matériau de soudure permet notamment de porter l'ensemble hybridé à des températures élevées si nécessaire, comme par exemple dans le cas d'une soudure sur carte. En effet, en l'absence de matériau de soudure, aucune précaution particulière n'est à prendre concernant les interconnexions entre les éléments mâle et femelle ;
▪ une force d'enfichage faible suffisante pour enficher les éléments mâle et femelle ;
▪ un procédé d'enfichage moins onéreux et pouvant fonctionner à une cadence élevée. En effet, une machine de positionnement du type « pick and place », rapide mais pouvant présenter une précision limitée, peut être utilisée pour pré-insérer les éléments mâles dans les éléments femelles à forte cadence, c'est-à-dire enficher partiellement ces éléments, grâce à l'autoalignement intrinsèque selon l'invention, puis les circuits ainsi partiellement hybridés peuvent être déplacés ensemble sans risque de désalignement vers une autre machine spécifique qui effectue l'enfichage final de tous les éléments de connexion. Un gain notable de cadence de production est ainsi obtenu ;
▪ la possibilité de créer des cartes ou des multiple chip module (MCM) « évolutifs » : une version de puce peut être remplacée par une version plus évoluée grâce aux interconnexions selon l'invention. Ce type d'évolution matérielle est à la fois facile à mettre en oeuvre par les constructeurs et difficile à mettre en oeuvre par les tiers qui ne disposent pas d'un outillage permettant un alignement d'une précision de l'ordre du micromètre.

## Revendications

1. Elément de connexion femelle (30), destiné à la connexion de composants électroniques, comportant une partie de guidage (32) creuse de forme évasée (32) pour la réception et le guidage d'un élément de connexion mâle (10) creux et une partie creuse d'enfichage (34), formée dans le prolongement de la partie de forme évasée (32), pour l'enfichage de l'élément de connexion mâle (10),
dans lequel :
- l'élément de connexion femelle (34) présente une section transversale ondulée sur toute sa hauteur ;
- la partie de guidage (32) comporte une ouverture (38) dont le diamètre d'un cercle inscrit (36) est supérieur au diamètre externe de l'élément de connexion mâle (10) de manière à recevoir celui-ci ;
- le diamètre du cercle inscrit (36) de la partie de guidage (32) décroit depuis l'ouverture (38) jusqu'à la partie d'enfichage (34) de manière à guider l'élément de connexion mâle (10) vers la partie d'enfichage;
- la partie d'enfichage (34) est réalisée dans un matériau déformable de sorte que le diamètre du cercle inscrit (36) de la partie d'enfichage (34) après l'enfichage de l'élément mâle (10) est plus grand qu'avant l'enfichage.

2. Système de connexion d'un premier composant électronique (14) avec un second composant électronique (16), comportant au moins une paire d'éléments de connexion mâle (10) et femelle (30) respectivement fixés au premier et second composants (14, 16), dans lequel :
▪ l'élément de connexion femelle (30) comporte une partie creuse de forme évasée (32) pour la réception et le guidage de l'élément de connexion mâle (10) creux et une partie creuse d'enfichage (34), formée dans le prolongement de la partie de forme évasée (32), pour l'enfichage de l'élément de connexion mâle (10) ;
▪ une partie à enficher de l'élément de connexion mâle (10) a un diamètre externe avant l'enfichage supérieur à un diamètre d'un cercle inscrit (36) de la partie d'enfichage (34) de l'élément de connexion femelle (30) ;
▪ l'élément de connexion femelle (34) et/ou l'élément de connexion mâle (10) présente une section transversale ondulée sur toute sa hauteur ;
▪ la partie de guidage (32) comporte une ouverture (38) dont le diamètre d'un cercle inscrit (36) est supérieur au diamètre externe de l'élément de connexion mâle (10) de manière à recevoir celui-ci ;
▪ le diamètre du cercle inscrit (36) de la partie de guidage (32) décroit depuis l'ouverture (38) jusqu'à la partie d'enfichage (34) de manière à guider l'élément de connexion mâle (10) vers la partie d'enfichage;
▪ la partie à enficher de l'élément de connexion mâle est réalisée dans un matériau déformable, de manière à se contracter lors de son enfichage dans la partie d'enfichage (34) de l'élément femelle (30), et/ou la partie d'enfichage (34) de l'élément de connexion femelle (30) est réalisée dans un matériau déformable de sorte que le diamètre du cercle inscrit (36) de la partie d'enfichage (34) après l'enfichage de la partie à enficher de l'élément mâle (10) est plus grand qu'avant l'enfichage.

3. Procédé de fabrication d'un élément de connexion femelle conforme à la revendication 1, consistant :
▪ à réaliser une couche apte à être gravée (54);
▪ à déposer sur la couche apte à être gravée (54) une couche non sensible à la gravure (56) et comportant une ouverture (58) à profil ondulé ;
▪ à appliquer une gravure isotrope sur ladite ouverture (58) de manière à former, dans la couche apte à être gravée (54), la partie de forme évasée (32);
▪ puis à appliquer une gravure anisotrope sur ladite ouverture (58) de manière à former, dans la couche apte à être gravée (54), la partie d'enfichage (34); et
▪ à retirer la couche non sensible à la gravure (56).

4. Procédé de fabrication d'un élément de connexion femelle conforme à la revendication 1, consistant :
▪ à réaliser un empilement d'au moins une couche supérieure (70) et une couche inférieure (72) aptes à être gravées, la couche supérieure étant gravée plus rapidement que la couche inférieure ;
▪ à déposer sur la couche supérieure (70) une couche non sensible à la gravure (56) et comportant une ouverture (58) à profil ondulé ;
▪ à appliquer une gravure sur ladite ouverture (58) de manière à former, dans les aux moins deux couches aptes à être gravée (70, 72), la partie de forme évasée (32) et la partie d'enfichage (34); et
▪ à retirer la couche non sensible à la gravure (56).

5. Procédé de fabrication d'un élément de connexion femelle selon la revendication 3 ou 4, dans lequel la ou les couches aptes à être gravées sont des couches de polymère de type diimide.

6. Procédé de fabrication d'un élément de connexion femelle selon l'une des revendications 3, 4 ou 5, comprenant le dépôt d'une couche de métal sur la paroi interne des parties gravées.

7. Procédé de fabrication d'un élément de connexion femelle selon la revendication 6, comprenant le retrait de la ou des couches aptes à être gravé.

## Patentansprüche

1. Weibliches Verbindungselement (30) zur Verbindung von Elektronikkomponenten, mit einem hohlen Führungsteil (32) mit einer konischen Form (32) zur Aufnahme und Führung eines hohlen, männlichen Verbindungselementes (10) und einem hohlen Steckteil (34), geformt in der Verlängerung des Teils mit konischer Form (32), zum Einstecken des männlichen Verbindungselementes (10),
bei dem
- das weibliche Verbindungselement (34) über seine gesamte Höhe einen gewellten Querschnitt aufweist;
- das Führungsteil (32) eine Öffnung (38) enthält, deren Inkreis- Durchmesser (36) größer ist, als der Außendurchmesser des männlichen Verbindungselementes (10), so dass dieses aufgenommen werden kann;
- der Inkreis- Durchmesser (36) des Führungsteils (32) von der Öffnung (38) bis zum Steckteil (34) abnimmt, so dass das männliche Verbindungselement (10) zum Steckteil geführt wird;
- das Steckteil (34) ist aus einem verformbaren Material ausgeführt, so dass der Inkreis- Durchmesser (36) des Steckteils (34) nach dem Einstecken des männlichen Verbindungselementes (10) größer ist, als vor dem Einstecken.

2. Verbindungssystem eines ersten elektronischen Bauteils (14) mit einem zweiten elektronischen Bauteil (16), das mindestens ein Paar männlicher und weiblicher Verbindungselemente (10, 30) enthält, die jeweils am ersten und zweiten Bauteil (14, 16) befestigt sind,
▪ bei dem das weibliche Verbindungselement (30) einen hohlen Abschnitt konischer Form (32) enthält, zur Aufnahme und Führung des hohlen, männlichen Verbindungselementes (10) und ein hohles Steckteil (34), geformt in der Verlängerung des Teils mit konischer Form (32), zum Einstecken des männlichen Verbindungselementes (10),
▪ ein Einsteckteil des männlichen Verbindungselementes (10) hat einen Außendurchmesser vor dem Einstecken, der größer ist als ein Inkreis-Durchmesser (36) des Steckteils (34) des weiblichen Verbindungselementes (30);
▪ das weibliche Verbindungselement (34) und oder das männliche Verbindungselement (10) weist über seine gesamte Höhe einen gewellten Querschnitt auf;
▪ das Führungsteil (32) enthält eine Öffnung (38), deren Inkreis- Durchmesser (36) höher ist, als der Außendurchmesser des männlichen Verbindungselementes (10), so dass dieses aufgenommen werden kann;
▪ der Inkreis- Durchmesser (36) des Führungsteils (32) nimmt von der Öffnung (38) zum Steckteil (34) hin ab, so dass das männliche Verbindungselement (10) zum Steckteil geführt wird;
▪ das Steckteil des männlichen Verbindungselementes ist aus einem verformbaren Material ausgeführt, so dass es sich beim Einstecken in das Steckteil (34) des weiblichen Verbindungselementes (30) zusammenzieht, und/ oder das Steckteil (34) des weiblichen Verbindungselementes (30) ist aus einem verformbaren Material ausgeführt, so dass der Inkreis- Durchmesser (36) des Steckteils (34) nach dem Einstecken des Steckteils des männlichen Verbindungselementes (10) größer ist, als vor dem Einstecken.

3. Verfahren zur Herstellung eines weiblichen Verbindungselementes gemäß Anspruch 1, das besteht:
▪ in der Ausführung einer ätzbaren Schicht (54);
▪ Ablagerung auf der ätzbaren Schicht (54) einer nicht ätzbaren Schicht (56), die eine Öffnung (58) mit gewelltem Profil enthält;
▪ Auftragen einer isotropen Gravur auf dieser Öffnung (58), so dass in der ätzbaren Schicht (54) das Teil mit konischer Form (32) geätzt wird;
▪ dann Auftragen einer anisotropen Gravur auf diese Öffnung (58), so dass in der ätzbaren Schicht (54) das Steckteil (34) gebildet wird; und
▪ Entfernung der nicht ätzbaren Schicht (56).

4. Verfahren zur Herstellung eines weiblichen Verbindungselementes gemäß Anspruch 1, das besteht:
▪ Ausführung eines Stapels von mindestens einer ätzbaren oberen Schicht (70) und einer ätzbaren unteren Schicht (72), die obere Schicht wird dabei schneller geätzt als die untere Schicht;
▪ Ablagerung auf der oberen Schicht (70) einer nicht ätzbaren Schicht (56), die eine Öffnung (58) mit gewelltem Profil enthält;
▪ Auftragen einer Gravur auf dieser Öffnung (58), so dass in den mindestens zwei ätzbaren Schichten (70, 72) das Teil mit konischer Form (32) und das Steckteil (34) geformt wird; und
▪ Entfernung der nicht ätzbaren Schicht (56).

5. Verfahren zur Herstellung eines weiblichen Verbindungselementes gemäß Anspruch 3 oder 4, in dem die ätzbare Schicht oder ätzbaren Schichten Polymerschichten vom Typ Diimin sind.

6. Verfahren zur Herstellung eines weiblichen Verbindungselementes gemäß einem der Ansprüche 3, 4 oder 5, umfassend die Ablagerung einer Metallschicht auf der Innenwand der geätzten Teile.

7. Verfahren zur Herstellung eines weiblichen Verbindungselementes gemäß Anspruch 6, umfassend die Entfernung der ätzbaren Schicht oder Schichten.

## Claims

1. A female connection element (30) for interconnection of electronic components, comprising a hollow flared portion (32) for receiving and guiding a male connection element (10) and a hollow mating portion (34), formed in continuation of the flared portion (32), for mating with the male connection element (10),
• wherein the female connection element (34) has a corrugated transverse cross-section along all its height;
• wherein the guiding portion (32) has an opening (38) which diameter of the inscribed circle (36) is greater than the external diameter of the male connection element (10) in order to receive said element;
• wherein the diameter of the inscribed circle (36) of the guiding portion (32) decreases from opening (38) to mating portion (34) in order to guide the male connection element (10) to mating portion ;
• wherein the mating portion (34) is made of a deformable material such that the diameter of the inscribed circle (36) of the mating portion (34) is greater after the mating of the male connection element (10) than before the mating.

2. A interconnection system of a first electronic component (14) with a second electronic component (16), at least comprising a pair of male connection element (10) and female connection element (30), respectively fixed to first and second components (14, 16),
• wherein the female connection element (30) comprises a hollow flared portion (32) for receiving and guiding the male connection element (10) and a hollow mating portion (34), formed in continuation of the flared portion (32), for mating with the male connection element (10),
• wherein a mating portion of the male connection element (10) has an external diameter before mating greater than the diameter of the inscribed circle (36) of the mating portion (34) of the female connection element (30) ;
• wherein the female connection element (34) and/or the male connection element (10) has a corrugated transverse cross-section along all its height;
• wherein the guiding portion (32) has an opening (38) which diameter of the inscribed circle (36) is greater than the external diameter of the male connection element (10) in order to receive said element;
• wherein the diameter of the inscribed circle (36) of the guiding portion (32) decreases from opening (38) to mating portion (34) in order to guide the male connection element (10) to mating portion ;
• wherein the mating portion of the male connection element (10) is made of a deformable material in order to to contract when it is fitted into the mating portion (34) of the female element (30), and/or the mating portion (34) of the female connection element (30) is made of a deformable material such that the diameter of the inscribed circle (36) of the mating portion (34) is greater after the mating of the male connection element (10) than before the mating

3. A method for manufacturing a female connection element of claim 1, comprising:
• forming a layer capable of being etched (54);
• depositing on the layer capable of being etched (54) a layer insensitive to etching (56) and comprising an opening (58) having a corrugated profile;
• applying an isotropic etching on said opening (58) to form, in the layer capable of being etched (54), the flared portion (32);
• applying an anisotropic etching on said opening (58) to form, in the layer capable of being etched (54), the mating portion (34); and
• removing the layer insensitive to etching (56).

4. A method for manufacturing the female connection element of claim 1, comprising:
• forming a stack of at least one upper layer (70) and one lower layer (72) capable of being etched, the upper layer being etched more rapidly than the lower layer;
• depositing on the upper layer (70) a layer insensitive to etching (56) and comprising an opening (58) having a corrugated profile;
• applying an etching to said opening (58) to form, in the at least two layers capable of being etched (70, 72), the flared portion (32) and the mating portion (34); and
• removing the layer insensitive to etching (56).

5. A method for manufacturing the female connection element of claim 3 or 4, wherein the layer(s) capable of being etched are diimide-type polymer layers.

6. The method for manufacturing a female connection element of any of claims 3, 4 or 5, comprising the deposition of a metal layer on the internal wall of the etched portions.

7. The method for manufacturing a female connection element of claim 6, comprising the removal of the layer(s) capable of being etched.
